# EUROPEAN PATENT SPECIFICATION

(11) **EP 2 819 179 B1**
(45) Date of publication and mention of the grant of the patent: **29.04.2020**
(21) Application number: 13752323.9
(22) Date of filing: 19.02.2013
(51) Int. Cl.: H01L 31/075, H01L 31/042, H01L 31/18

(54) **MULTIPLE BAND GAP TANDEM SOLAR CELL AND METHOD FOR FORMING SAME**
TANDEMSOLARZELLE MIT MEHREREN BANDSPALTEN UND VERFAHREN ZUR HERSTELLUNG DAVON
CELLULE SOLAIRE TANDEM À BANDE INTERDITE MULTIPLE ET SON PROCÉDÉ DE FORMATION

(30) Priority: 20.02.2012 KR 20120016929
(43) Date of publication of application: 31.12.2014
(73) Proprietor: Korea University Research and Business Foundation, Sejong Campus, Sejong-ro Jochiwon-eup Sejong-si 30019 (KR)
(72) Inventor: HONG, Munpyo, Seongnam-si Gyeonggi-do 463-915 (KR); JANG, Jin Nyeong, Seongnam-si Gyeonggi-do 463-967 (KR)
(74) Representative: Beck Greener LLP
(86) International application number: PCT/KR2013/001288
(87) International publication number: WO 2013/125831

(56) References cited:
- JP-A- H10 294 484
- JP-A- 2011 135 053
- KR-A- 20080 035 885
- KR-A- 20100 105 194
- KR-B1- 101 087 351
- US-A- 6 043 427
- JIN NYOUNG JANG ET AL: "Oxygen elimination effect in silicon thin film by neutral beam assisted CVD system at room temperature", 35TH IEEE PHOTOVOLTAIC SPECIALISTS CONFERENCE (PVSC), 20-25 JUNE 2010, HONOLULU, HI, USA, IEEE, PISCATAWAY, NJ, USA, 20 June 2010 (2010-06-20), pages 3681-3685, XP031786458, ISBN: 978-1-4244-5890-5
- TCHAKAROV S ET AL: "Modeling of reverse bias dark currents in pin structures using amorphous and polymorphous silicon", JOURNAL OF NON-CRYSTALLINE SOLIDS, NORTH-HOLLAND PHYSICS PUBLISHING. AMSTERDAM, NL, vol. 338-340, 15 June 2004 (2004-06-15), pages 766-771, XP004514698, ISSN: 0022-3093, DOI: 10.1016/J.JNONCRYSOL.2004.03.087
- YOO S ET AL: "Hyperthermal neutral beam sources for material processing (invited)", REVIEW OF SCIENTIFIC INSTRUMENTS, AIP, MELVILLE, NY, US, vol. 79, no. 2, 15 January 2008 (2008-01-15), pages 2C301-2C301, XP012115221, ISSN: 0034-6748, DOI: 10.1063/1.2801343

## Description

### TECHNICAL FIELD

The embodiments described herein pertain generally to a multiple band gap laminating solar cell and a method for forming the same.

### BACKGROUND ART

Due to exhaustion of limited energy resources, interests in solar cells producing electricity by using solar light, which is an unlimited energy resource, have been increased, and accordingly, development of the solar cells are being continuously promoted.

Depending on materials for solar cells, the solar cells may be divided into an inorganic solar cell consisting of an inorganic material such as silicon and a chemical semiconductor, and an organic solar cell containing an organic material. The organic solar cell has high economic efficiency, compared to the inorganic solar cell, but has a problem in that it provides relatively low energy conversion efficiency. Accordingly, the inorganic solar cell is used more frequently than the organic solar cell, and thus, is being intensively researched.

More specifically, the inorganic solar cell may be divided into a bulk type and a thin film type depending on a type of a substrate. A bulk-type silicon solar cell may be further divided into a single crystal silicon solar cell and a polycrystal silicon solar cell depending on a type of a silicon crystal. The single crystal solar cell is advantageous in that it provides satisfactory dielectric efficiency and can relatively effectively work even on a cloudy day, thanks to the same direction of crystals and nonexistence of hindrance in movement of electrons. Meanwhile, the polycrystal silicon solar cell is advantageous in that it does not require an additional purifying process, and is inexpensive since it uses a less quantity of wafers than the single crystal type.

In order to utilize the advantages of the single crystal silicon and the polycrystal silicon, researches on a hydrothermal method, a czochralski method, and a chemical vapor deposition method, etc., have been promoted. These methods can form crystalline silicon by controlling component molecules to be arranged in order.

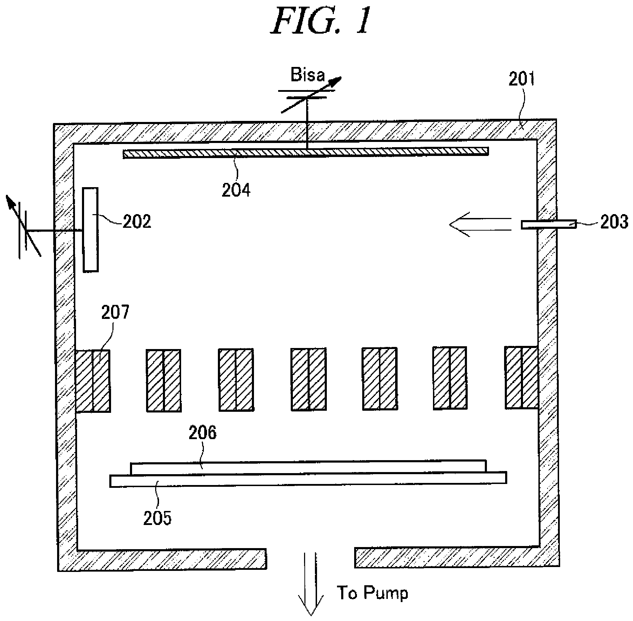

In this regard, Korean Patent Application Publication No. 2010-010519 (Title of Invention: Thin Film Transistor and Manufacturing Method thereof) describes a method for manufacturing a thin film transistor by using a neutral particle beam device like one illustrated in **FIG. 1** and a chemical vapor deposition method. **FIG. 1** shows a conventional neutral particle beam device.

Meanwhile, the inorganic solar cell has a limit in improving the energy conversion efficiency, if the crystalline silicon is used as a single absorbing layer. Accordingly, in order to improve the efficiency, there have been attempts to stack two (2) or more semiconductor layers with different band gaps.

In this regard, Korean Patent Application Publication No. 2010-0011128 (Title of Invention: Solar Cell and Manufacturing Method thereof) describes a solar cell, in which at least two (2) layers of an amorphous silicon layer, a microcrystalline silicon layer, a hydrogenated amorphous silicon layer, an amorphous silicon germanium layer, a protocrystalline silicon layer, and an amorphous silicon carbide layer are formed on an intrinsic semiconductor layer. However, the solar cell has a problem since loss of charge movement occurs due to discontinuous arrangement at the facing surfaces of the layers, and there is difficulty for improving the efficiency due to difference in work function among the layers.

US Patent No. 6,043,427 describes a photovoltaic device comprising a pin-structure semiconductor layer formed by superimposing a p-type semiconductor layer, an i-type semiconductor layer and an n-type semiconductor layer. The semiconductor layers are made of a non-single crystal semiconductor material. The document discloses an i-type microcrystalline silicon layer as having a non-uniform grain size distribution of crystal grains in the film thickness direction and being formed by means of high frequency plasma chemical vapor deposition.

### DISCLOSURE OF THE INVENTION

### PROBLEMS TO BE SOLVED BY THE INVENTION

In view of the foregoing problems, example embodiments provide a method for forming a multiple band gap laminating solar cell, which can facilitate energy control by a neutral particle beam device.

Example embodiments also provide a multiple band gap laminating solar cell, which has an optical band gap adjusted based on a change in a crystal structure according to deposited height, and provides significantly high energy conversion efficiency, compared to conventional solar cells.

However, the problems sought to be solved by the present disclosure are not limited to the above description, and other problems can be clearly understood by those skilled in the art from the following description.

### MEANS FOR SOLVING THE PROBLEMS

In one example embodiment, a multiple band gap laminating solar cell, comprising:
a substrate ; lower electrode conductor stacked on the substrate; a p-type nanocrystal silicon layer to which impurities are added, wherein the p-type nanocrystal silicon layer is stacked on the lower electrode conductor; an intrinsic semiconductor layer stacked on the p-type nanocrystal silicon layer; an n-type nanocrystal silicon layer to which impurities are added, wherein the n-type nanocrystal silicon layer is stacked on the intrinsic semiconductor layer, and an anti-reflection film stacked on the n-type nanocrystal silicon layer, wherein the intrinsic semiconductor layer has an optical band gap which varies according to a change in the crystal structure thereof due to a deposited height of the intrinsic semiconductor.

In another example embodiment, a method for forming a multiple band gap laminating solar cell, comprising: (a) forming a lower electrode conductor on a substrate; (b) forming a p-type nanocrystal silicon layer on the lower electrode conductor; (c) forming an intrinsic semiconductor layer comprising a nanocrystal silicon layer through neutral particle beam irradiation onto the p-type nanocrystal silicon layer; (d) forming an n-type nanocrystal silicon layer on the intrinsic semiconductor layer; and (e) forming an anti-reflection film on the n-type nanocrystal silicon layer, wherein (c) adjusts an optical band gap of the nanocrystal silicon layer by controlling energy to be supplied for production of the neutral particle beams according to a deposited height of the intrinsic semiconductor.

### EFFECT OF THE INVENTION

In accordance with the above-described example embodiments, since the multiple band gap laminating solar cell includes an intrinsic semiconductor layer having a crystal structure and an optical band gap, which vary according to deposited height, the energy conversion efficiency of the solar cell can be improved.

In accordance with the above-described example embodiments, since the method for forming a multiple band gap laminating solar cell forms a p-type nanocraystal silicon layer, an intrinsic semiconductor layer, and an n-type nanocrystal silicon layer in the same equipment to have the same nanostructure through neutral particle beam irradiation, charge losses at the facing portions of the layers can be minimized.

In addition, in accordance with the above-described example embodiments, since the method for forming a multiple band gap laminating solar cell forms an intrinsic semiconductor with a nanocrystal structure, a degradation phenomenon occurring with lapse of time can be reduced.

### BRIEF DESCRIPTION OF THE DRAWINGS

**FIG. 1** shows a conventional neutral particle beam device.
**FIG. 2** shows a multiple band gap laminating solar cell in accordance with an example embodiment.
**FIG. 3** shows a method for forming a multiple band gap laminating solar cell in accordance with an example embodiment.
**FIG. 4** shows a neutral particle beam device for forming a multiple band gap laminating solar cell in accordance with the example embodiment.
**FIG. 5** shows changing a crystal structure of silicon by using a neutral particle beam device.
**FIG. 6** shows a nanocrystal silicon layer formed by using a neutral particle beam device.
**FIG. 7** shows variation of an optical band gap depending on a voltage applied to a nanocrystal silicon layer in accordance with an example embodiment.

### DETAILED DESCRIPTION

Hereinafter, example embodiments will be described in detail with reference to the accompanying drawings so that inventive concept may be readily implemented by those skilled in the art. However, it is to be noted that the present disclosure is not limited to the example embodiments but can be realized in various other ways. In the drawings, certain parts not directly relevant to the description are omitted to enhance the clarity of the drawings, and like reference numerals denote like parts throughout the whole document.

Throughout the whole document, the terms "connected to" or "coupled to" are used to designate a connection or coupling of one element to another element and include both a case where an element is "directly connected or coupled to" another element and a case where an element is "electronically connected or coupled to" another element via still another element.

Throughout the whole document, the term "on" that is used to designate a position of one element with respect to another element includes both a case that the one element is adjacent to the another element and a case that any other element exists between these two elements.

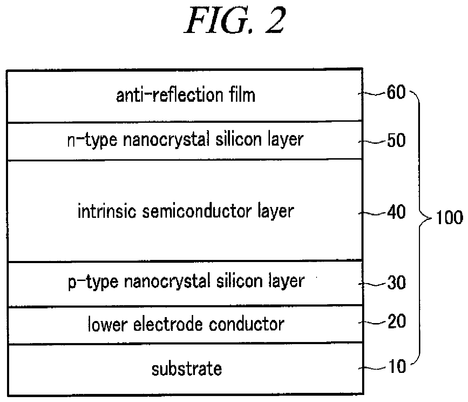

**FIG. 2** shows a multiple band gap laminating solar cell in accordance with an example embodiment.

A multiple band gap laminating solar cell 100 in accordance with an example embodiment includes a substrate 10. For example, glass or a polymer may be used for the substrate 10.

In addition, the multiple band gap laminating solar cell 100 includes a lower electrode conductor 20 stacked on the substrate 10.

In addition, the multiple band gap laminating solar cell 100 includes a p-type nanocrystal silicon layer 30, which is stacked on the lower electrode conductor 20, and to which impurities are added. The p-type nanocrystal silicon layer 30 may have a thickness of 0.5 nm to 1000 *µ*m.

In addition, the multiple band gap laminating solar cell 100 includes an intrinsic semiconductor layer 40 stacked on the p-type nanocrystal silicon layer, to which impurities are added. The intrinsic semiconductor layer 40 may be formed through control of neutral particle beams according to deposited height. When the intrinsic semiconductor layer 40 is formed through control of neutral particle beams according to deposited height, the crystal structure of the intrinsic semiconductor layer 40 is changed, and as a result, the optical band gap of the intrinsic semiconductor layer 40 may vary. In addition, the intrinsic semiconductor layer 40 may be formed to have a thickness of 0.5 nm to 1000 *µ*m. Further, the intrinsic semiconductor layer 40 may be formed between the p-type nanocrystal silicon layer 30 and an n-type nanocrystal silicon layer 50, which will be described later, to have the same effect as that of a semiconductor having a PIN junction structure.

In addition, the intrinsic semiconductor layer 40 may have an optical band gap having a smaller value at the portion facing the p-type nanocrystal silicon layer 30, than the portion facing the n-type nanocrystal silicon layer 50.

For example, in the multiple band gap laminating solar cell 100, solar light is absorbed through an anti-reflection film 60, which will be described later, and passes through the n-type nanocrystal silicon layer 50, which will be described later, to move through the intrinsic semiconductor layer 40, the p-type nanocrystal silicon layer 30, and the lower electrode conductor 20 in this order. That is, the optical band gap of the intrinsic semiconductor layer 40 is the largest at the portion facing the n-type nanocrystal silicon layer 50, and the smallest at the portion facing the p-type nanocrystal silicon layer 30. The optical band gap of the intrinsic semiconductor layer 40 may be gradually reduced as it is close toward the portion facing the p-type nanocrystal silicon layer 30 from the portion facing the n-type nanocrystal silicon layer 50.

Further, a crystal structure size of the intrinsic semiconductor layer 40 may become gradually small toward the portion facing the n-type nanocrystal silicon layer 50 from the portion facing the p-type nanocrystal silicon layer 30.

Specifically, a layer consisting of the largest crystal structures may be formed at the portion facing the p-type nanocrystal silicon layer 30, and a layer consisting of the smallest crystal structures may be formed at the portion facing the n-type nanocrystal silicon layer 50. In addition, a multiple number of layers consisting of crystal structures, which become gradually small toward the portion facing the n-type nanocrystal silicon layer 50 from the portion facing the p-type nanocrystal silicon layer 30, may be formed within the intrinsic semiconductor layer 40.

As described above, since the solar light absorbed in the multiple band gap laminating solar cell 100 moves, the optical band gap of the intrinsic semiconductor layer 40 may be the largest at the portion facing the n-type nanocrystal silicon layer 50, and become gradually small to be finally the smallest at the portion facing the p-type nanocrystal silicon layer 30. Like this, the crystal structure size and the optical band gap of the intrinsic semiconductor layer 40 appear to be highly closely related to each other. By increasing an amount of energy to be absorbed through control of the band gap of the multiple band gap laminating solar cell 100 and improving the energy conversion efficiency, a high-efficient solar cell can be formed.

Returning to **FIG. 2**, the multiple band gap laminating solar cell 100 includes the n-type nanocrystal silicon layer 50, which is stacked on the intrinsic semiconductor layer 40, and to which impurities are added. The n-type nanocrystal silicon layer 50 may have a thickness of 0.5 nm to 1000 *µ*m.

Impurities may be added to the above-described p-type nanocrystal silicon layer 30 and n-type nanocrystal silicon layer 50 for improvement of semiconductor characteristics. For example, arrangement of crystal structures of each of the p-type nanocrystal silicon layer 30, the intrinsic semiconductor layer 40, and the n-type nanocrystal silicon layer 50 may be discontinuous at the facing surfaces of the layers. Even in the case where layers formed of the same material are stacked, crystal structures of each of the layers may have discontinuous arrangement. Due to the discontinuous arrangement of the crystal structures of the p-type nanocrystal silicon layer 30, the intrinsic semiconductor layer 40, and the n-type nanocrystal silicon layer 50, movement of charges may be restricted. Accordingly, in order to avoid the discontinuous arrangement of the crystal structures of the p-type nanocrystal silicon layer 30, the intrinsic semiconductor layer 40, and the n-type nanocrystal silicon layer 50, each of the layers may be deposited while continuously controlling neutral particle beam energy, which will be described later.

Depositing the p-type nanocrystal silicon layer 30, the intrinsic semiconductor layer 40, and the n-type nanocrystal silicon layer 50 while continuously controlling neutral particle beam energy as described above may be performed by using a device improved from the conventional neutral particle beam device of **FIG. 1****.** Descriptions in this regard will be provided later.

Returning to **FIG. 2****,** the multiple band gap laminating solar cell 100 includes an anti-reflection film stacked on the n-type nanocrystal silicon layer 50. For example, the anti-reflection film 60 may be an area absorbing solar light. Also, the anti-reflection film 60 may prevent the solar light, which has been absorbed but reflected by the components located below the anti-reflection film 60, from being leaked outside. In other words, the anti-reflection film 60 may enable solar light to be absorbed through into the multiple band gap laminating solar cell 100, and prevent the absorbed solar light from being reflected by the components located below the anti-reflection film 60 and leaked outside the multiple band gap laminating solar cell 100.

The above-described multiple band gap laminating solar cell 100 may be actually applied in the state illustrated in **FIG. 2****.** That is, the substrate 10 is located at the bottommost portion, the lower electrode conductor 20, the p-type nanocrystal silicon layer 30, the intrinsic semiconductor layer 40, and the n-type nano-crystal silicon layer 50 are located thereon in this order, and the anti-reflection film 60 is located at the topmost portion. Accordingly, solar light is absorbed through the anti-reflection film 60.

However, the multiple band gap laminating solar cell 100 may be actually applied in the state that the stacking order is reversed. That is, the anti-reflection film 60 is located at the bottommost portion, the n-type nanocrystal silicon layer 50, the intrinsic semiconductor layer 40, the p-type nanocrystal silicon layer 30, and the lower electrode conductor 20 are located thereon in this order, and the substrate 10 may be located at the topmost portion. Accordingly, solar light is absorbed through the substrate 10.

In this case, the intrinsic semiconductor layer 40 may be formed to have an optical band gap having a larger value at the portion facing the p-type nanocrystal silicon layer 30, than the portion facing the n-type nanocrystal silicon layer 50. In addition, the crystal structure size of the intrinsic semiconductor layer 40 may become gradually large toward the portion facing the n-type nanocrystal silicon layer 50 from the portion facing the p-type nanocrystal silicon layer 30.

Hereinafter, a method for forming a multiple band gap laminating solar cell in accordance with an example embodiment will be described.

For reference, a method for forming a multiple band gap laminating solar cell in accordance with an example embodiment relates to a method for forming the multiple band gap laminating solar cell 100 in accordance with an example embodiment. Thus, components similar to the components described with regard to the multiple band gap laminating solar cell 100 in accordance with the above-described example embodiment will be denoted by the same reference numerals as used for the components of the multiple band gap laminating solar cell 100, and descriptions thereof will be omitted.

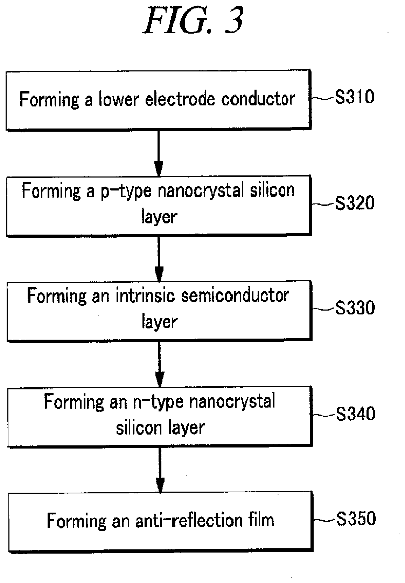

**FIG. 3** is a flowchart of the method for forming the multiple band gap laminating solar cell in accordance with an example embodiment.

With reference to **FIG. 3****,** the method for forming the multiple band gap laminating solar cell in accordance with an example embodiment forms the lower electrode conductor 20 on the substrate 10 (S310).

Next, the p-type nanocrystal silicon layer 30 is formed on the lower electrode conductor 20 (S320).

Next, the intrinsic semiconductor layer 40 including a nanocrystal silicon layer is formed on the p-type nanocrystal silicon layer 30 through neutral particle beam irradiation (S330).

Next, the n-type nanocrystal silicon layer 50 is formed on the intrinsic semiconductor layer 40 (S340).

Next, the anti-reflection layer 60 is formed on the n-type nanocrystal silicon layer 50 (S350).

The foregoing stages (S320, S330, and S340) may form the p-type nanocrystal silicon layer 30, the intrinsic semiconductor layer 40, and the n-type nanocrystal silicon layer 50 through the process of irradiating neutral particle beams.

Further, in S330, the optical band gap of the intrinsic semiconductor layer 40 may be adjusted by controlling energy to be supplied for production of neutral particle beams.

For example, when neutral particle beam energy is irradiated onto the nanocrystal semiconductor layer, a size, a crystal capacity, and doping efficiency of nanocrystals contained in the nanocrystal semiconductor layer vary so that the optical band gap of the nanocrystal semiconductor layer can be adjusted.

The variation of the optical band gap of the nanocrystal semiconductor layer according to the change in the size, the crystal capacity and the doping efficiency of the nanocrystals contained in the nanocrystal semiconductor layer is described. For example, when the size of the nanocrystals contained in the nanocrystal semiconductor layer increases, the optical band gap of the nanocrystal semiconductor layer may be reduced. In addition, as the crystal capacity of the nanocrystals contained in the nanocrystal semiconductor layer is large, the optical band gap of the nanocrystal semiconductor layer may be changed into an optical band gap of nanocrystals in the pure state. Further, as the doping concentration of the nanocrystals contained in the nanocrystal semiconductor layer is high, the optical band gap may be reduced. With the combined interaction of the above-described there (3) circumstances, the optical band gap of the nanocrystal semiconductor layer can be adjusted by controlling energy when irradiating neutral particle beams.

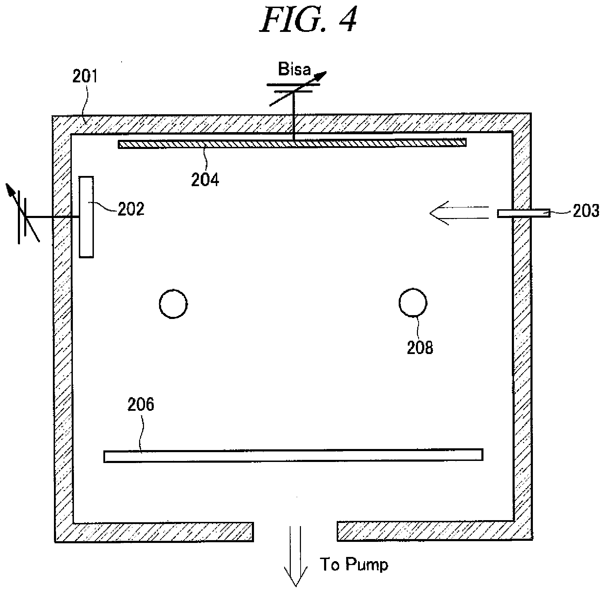

**FIG. 4** shows a neutral particle beam device for forming a multiple band gap laminating solar cell in accordance with an example embodiment.

Forming the intrinsic semiconductor layer 40 will be described with reference to **FIG. 4****.**

The neutral particle beam device (201) of **FIG. 4** is improved over the conventional neutral particle beam device (201) of **FIG. 1** to replace the magnet array limiter 207 of the conventional neutral particle beam device (201) with a plasma production antenna 208 to increase a depositing rate of gas atoms, and enable using plasma radicals with higher efficiency. Further, the neutral particle beam device (201) of **FIG. 4** has increased the likelihood that neutral particle beams will reach the substrate. In addition, neutral particle beam irradiation by the neutral particle beam device (201) may be performed based on a chemical vapor deposition method, a sputter method or a combination thereof. Since the neutral particle beam device (201) can irradiate neutral particle beams having optimal necessary energy according to processing stages, it can eliminate the problem of degradation of a lower thin film resulting from plasma, and deposit a thin film without an incubation area.

The p-type nanocrystal silicon layer 30, which is a nanocrystal silicon layer, the intrinsic semiconductor layer 40, and the n-type nanocrystal silicon layer 50 are formed through the neutral particle beam device (201) of **FIG. 4****,** and since continuous processing is possible through the same equipment, a nanostructure having no discontinuous surface can be formed. In addition, discontinuous arrangement of the crystal structures of the p-type nanocrystal silicon layer 30, the intrinsic semiconductor layer 40, and the n-type nanocrystal silicon layer 50 at their facing portions is reduced, so that losses of charges can be reduced, and as a result, the efficiency of the multiple band gap laminating solar cell 100 can be improved.

In addition, the intrinsic semiconductor layer 40 can be formed through the neutral particle beam device (201) of **FIG. 4****.** In this case, the intrinsic semiconductor layer 40 may be deposited by controlling energy to be supplied for production of neutral particle beams in the neutral particle beam device (201) of **FIG. 4****,** according to the deposited height of the intrinsic semiconductor layer 40. Through this depositing process, the optical band gap of the intrinsic semiconductor layer 40 can be formed to become larger or smaller as it is close to the n-type nanocrystal silicon layer 50.

Specifically, the energy to be supplied for production of neutral particle beams may be supplied to become gradually small, according to the deposited height of the intrinsic semiconductor layer 40. If the intrinsic semiconductor 40 is stacked while supplying the energy to become gradually small, the optical band gap of the portion facing the p-type nanocrystal silicon layer 30 may be formed at 1.4 eV. By controlling the energy to be supplied for production of neutral particle beams such that the optical band gap gradually increases as the stacked height of the intrinsic semiconductor layer 40 becomes high, the optical band gap of the portion facing the n-type nanocrystal silicon layer 50 may be 2.2 eV. In addition, a layer having an optical band gap of 1.8 eV may be further stacked between the optical band gaps of 1.4 eV and 2.2 eV, respectively.

In reverse, the energy to be supplied for production neutral particle beams may be supplied to become gradually large, according to the deposited height of the intrinsic semiconductor layer 40. If the intrinsic semiconductor layer 40 is stacked while supplying the energy to become gradually large, the optical band gap of the portion facing the p-type nanocrystal silicon layer 30 may be formed at 2.2 eV. By controlling the energy to be supplied for production of neutral particle beams such that the optical band gap is gradually reduced as the stacked height of the intrinsic semiconductor layer 40 increases, the optical band gap of the portion facing the n-type nanocrystal silicon layer 50 may be 1.8 eV.

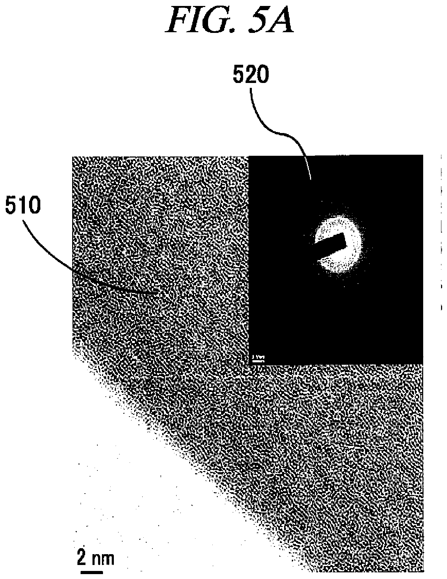

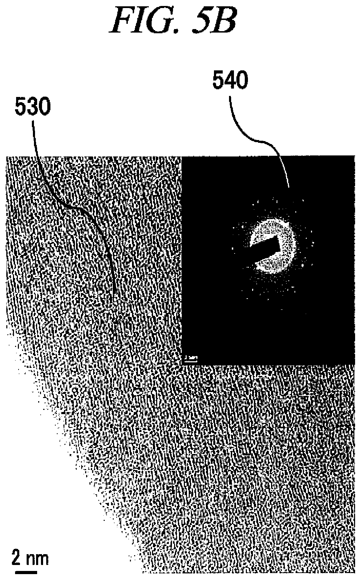

**FIG. 5** shows changing crystal structures of silicon by using the neutral particle beam device.

A silicon layer formed by using the above-described neutral particle beam device is described with reference to **FIG. 5****.** **(a)** of **FIG. 5** shows a silicon layer prior to irradiation of neutral particle beams through the neutral particle beam device. When seeing the silicon layer shown in **(a)** of **FIG. 5** through a transmission electron microscopy, a silicon layer 510 having an amorphous crystal structure can be observed. In addition, an electron diffraction pattern 520 of the amorphous silicon layer can be identified through **(a)** of **FIG. 5****.** When neutral particle beams are irradiated to the silicon layer shown in **(a)** of **FIG. 5** by using the neutral particle beam device, the amorphous silicon layer can be changed into a nanocrystal silicon layer 530 as shown in **(b)** of **FIG. 5****,** and it is identified that the electron diffraction pattern 540 of the changed nanocrystal silicon layer has also been changed.

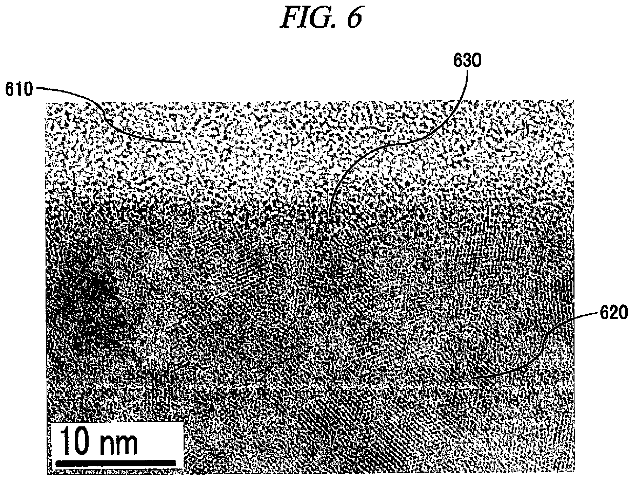

**FIG. 6** shows the nanocrystal silicon layer formed by using the neutral particle beam device.

With reference to **FIG. 6**, it is identified that in the silicon layer, to which neutral particle beams have been irradiated by using the above-described neutral particle beam device, an interface 630 is formed between a silicon substrate layer 610 and a nanocrystal silicon layer 620. In this case, it is identified that there is no incubation layer between the silicon film formed through the neutral particle beam irradiation and an insulating film.

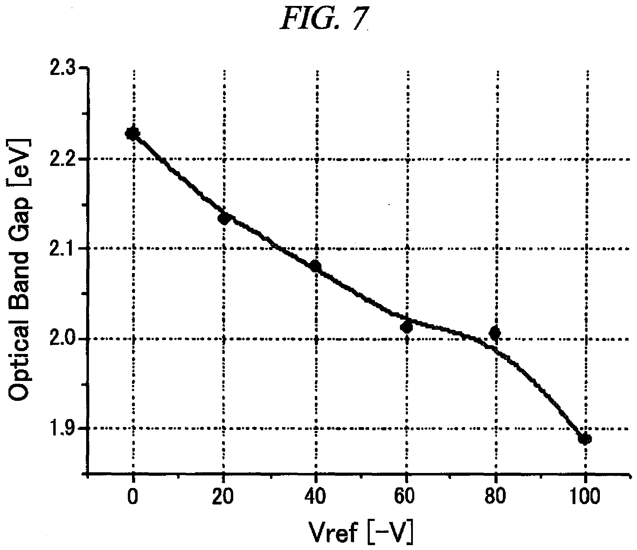

**FIG. 7** shows variation of the optical band gap according to a voltage applied to the nanocrystal silicon layer in accordance with an example embodiment.

The relationship between the energy to be supplied for production of neutral particle beams in the above-described neutral particle beam device and the optical band gap of the intrinsic semiconductor 40 is described with reference to **FIG. 7****.** From **FIG. 5****,** it is identified that the optical band gap of the intrinsic semiconductor layer 40 is reduced as an applied voltage increases. Specifically, when the intrinsic semiconductor layer 40 of the portion facing the p-type nanocrystal silicon layer 30 is stacked, a high voltage of 100 V may be applied to adjust the optical band gap to be 1.4 eV. In addition, when the intrinsic semiconductor layer 40 of the portion facing the n-type nanocrystal silicon layer 50 is stacked, a voltage of 0 V may be applied to adjust the optical band gap to be 2.2 eV.

As described above, when the intrinsic semiconductor layer 40 is stacked, the optical band gap of the intrinsic semiconductor layer 40 may be adjusted by controlling the energy to be supplied according to the stacked height. Likewise, by performing the same processing for the p-type nanocrystal silicon layer 30 and the n-type nanocrystal silicon layer 50 as that for the intrinsic semiconductor layer 40, the optical band gap of the layers may be adjusted.

The above description of the example embodiments is provided for the purpose of illustration, and it would be understood by those skilled in the art that various changes and modifications may be made without changing technical conception and essential features of the example embodiments. Thus, it is clear that the above-described example embodiments are illustrative in all aspects and do not limit the present disclosure. For example, each component described to be of a single type can be implemented in a distributed manner. Likewise, components described to be distributed can be implemented in a combined manner.

## Claims

1. A solar cell laminated to have multiple band gap values, comprising:
a substrate (10) ;
a lower electrode conductor (20) stacked on the substrate (10);
a p-type nanocrystal silicon layer (30) doped with p-type impurities, wherein the p-type nanocrystal silicon layer (30) is stacked on the lower electrode conductor;
an intrinsic semiconductor layer (40) stacked on the p-type nanocrystal silicon layer;
an n-type nanocrystal silicon layer (50) doped with n-type impurities, wherein the n-type nanocrystal silicon layer (50) is stacked on the intrinsic semiconductor layer, and
an anti-reflection film (60) stacked on the n-type nanocrystal silicon layer(50),
wherein the intrinsic semiconductor layer (40) is formed through irradiation by a neutral particle beam device (201), which controls irradiation energy according to a deposited height of the intrinsic semiconductor layer (40),
the intrinsic semiconductor layer (40) comprises a nanocrystal silicon layer which has a nanocrystal structure and an optical band gap which varies according to a change in the nanocrystal structure thereof due to the deposited height of the intrinsic semiconductor layer (40), and
the optical band gap has multiple band gap values depending on the deposited height,
wherein the energy supplied to the neutral particle beam device (201) is gradually increased as the deposited height of the intrinsic semiconductor layer (40) becomes higher, so that the optical band gap of the intrinsic semiconductor layer (40) becomes gradually smaller, or
the energy supplied to the neutral particle beam device (201) is gradually reduced as the deposited height of the intrinsic semiconductor layer (40) becomes higher, so that the optical band gap of the intrinsic semiconductor layer (40) becomes gradually larger.

2. The solar cell of claim 1,
wherein the intrinsic semiconductor layer (40) has an optical band gap having a smaller value at a portion facing the p-type nanocrystal silicon layer (30) than a portion facing the n-type nanocrystal silicon layer.

3. The solar cell of claim 2,
wherein a crystal structure size of the intrinsic semiconductor layer (40) becomes gradually small toward the portion facing the n-type nanocrystal silicon layer (50) from the portion facing the p-type nanocrystal silicon layer.

4. The solar cell of claim 1,
wherein the intrinsic semiconductor layer (40) has an optical band gap having a larger value at the portion facing the p-type nanocrystal silicon layer (30) than the portion facing the n-type nanocrystal silicon layer.

5. The solar cell of claim 4,
wherein a crystal structure size of the intrinsic semiconductor layer (40) becomes gradually large toward the portion facing the n-type nanocrystal silicon layer (50) from the portion facing the p-type nanocrystal silicon layer.

6. The solar cell of claim 1,
wherein the p-type nanocrystal silicon layer (30) has a thickness of 0.5 nm to 1000 *µ*m.

7. The solar cell of claim 1,
wherein the intrinsic semiconductor layer (40) has a thickness of 0.5 nm to 1000 *µ*m.

8. The solar cell of claim 1,
wherein the n-type nanocrystal silicon layer (50) has a thickness of 0.5 nm to 1000 *µ*m.

9. A method for forming a solar cell laminated to have multiple band gap values, comprising:
(a) forming a lower electrode conductor (20) on a substrate (10);
(b) forming a p-type nanocrystal silicon layer (30) on the lower electrode conductor (20);
(c) forming an intrinsic semiconductor layer (40) comprising a nanocrystal silicon layer through irradiation by a neutral particle beam device (201), onto the p-type nanocrystal silicon layer (30);
(d) forming an n-type nanocrystal silicon layer (50) on the intrinsic semiconductor layer (40); and
(e) forming an anti-reflection film (60) on the n-type nanocrystal silicon layer (50),
wherein the optical band gap has multiple band gap values depending on the deposited height,
wherein in the step (c) the energy to be supplied for production of neutral particle beams in the neutral particle beam device (201) is controlled according to a deposited height of the intrinsic semiconductor layer (40),
the nanocrystal silicon layer has a nanocrystal structure and an optical band gap which varies according to a change in the nanocrystal structure thereof due to the deposited height of the intrinsic semiconductor layer (40) and
wherein in the step (c), the energy supplied to the neutral particle beam device (201) is gradually increased as the deposited height of the intrinsic semiconductor layer (40) becomes higher, so that the optical band gap of the intrinsic semiconductor layer (40) becomes gradually smaller or,
in the step (c), the energy supplied to the neutral particle beam device (201) is gradually reduced as the deposited height of the intrinsic semiconductor layer (40) becomes higher, so that the optical band gap of the intrinsic semiconductor layer (40) becomes gradually larger.

10. The method for forming a solar cell of claim 9, wherein in the steps (b) or (d) the nanocrystal silicon layer is formed through neutral particle beam irradiation.

## Patentansprüche

1. Solarzelle, die laminiert ist, um mehrere Bandlückenwerte aufzuweisen, umfassend:
ein Substrat (10);
einen unteren Elektrodenleiter (20), der auf dem Substrat (10) gestapelt ist;
eine p-Typ-Nanokristall-Siliziumschicht (30), die mit p-Typ-Verunreinigungen dotiert ist, wobei die p-Typ-Nanokristall-Siliziumschicht (30) auf dem unteren Elektrodenleiter gestapelt ist;
eine intrinsische Halbleiterschicht (40), die auf der p-Typ-Nanokristall-Siliziumschicht gestapelt ist;
eine n-Typ-Nanokristall-Siliziumschicht (50), die mit n-Typ-Verunreinigungen dotiert ist, wobei die n-Typ-Nanokristall-Siliziumschicht (50) auf der intrinsischen Halbleiterschicht gestapelt ist;
eine Antireflexfolie (60), die auf der n-Typ-Nanokristall-Siliziumschicht (50) gestapelt ist;
wobei die intrinsische Halbleiterschicht (40) durch Bestrahlung durch eine Neutralteilchenstrahlvorrichtung (201) gebildet wird, die eine Bestrahlungsenergie gemäß einer abgeschiedenen Höhe der intrinsischen Halbleiterschicht (40) steuert,
die intrinsische Halbleiterschicht (40) eine Nanokristall-Siliziumschicht umfasst, die eine Nanokristallstruktur und eine optische Bandlücke aufweist, die gemäß einer Veränderung in der Nanokristallstruktur davon aufgrund der abgeschiedenen Höhe der intrinsischen Halbleiterschicht (40) variiert, und
die optische Bandlücke mehrere Bandlückenwerte in Abhängigkeit von der abgeschiedenen Höhe aufweist,
wobei die Energie, die der Neutralteilchenstrahlvorrichtung (201) zugeführt wird, allmählich erhöht wird, während die abgeschiedene Höhe der intrinsischen Halbleiterschicht (40) höher wird, so dass die optische Bandlücke der intrinsischen Halbleiterschicht (40) allmählich kleiner wird, oder
die Energie, die der Neutralteilchenstrahlvorrichtung (201) zugeführt wird, allmählich verringert wird, während die abgeschiedene Höhe der intrinsischen Halbleiterschicht (40) höher wird, so dass die optische Bandlücke der intrinsischen Halbleiterschicht (40) allmählich größer wird.

2. Solarzelle nach Anspruch 1,
wobei die intrinsische Halbleiterschicht (40) eine optische Bandlücke mit einem kleineren Wert an einem Abschnitt, der der p-Typ-Nanokristall-Siliziumschicht (30) zugewandt ist, als einem Abschnitt, der der n-Typ-Nanokristall-Siliziumschicht zugewandt ist, aufweist.

3. Solarzelle nach Anspruch 2,
wobei eine Kristallstrukturgröße der intrinsischen Halbleiterschicht (40) allmählich zu dem Abschnitt, der der n-Typ-Nanokristall-Siliziumschicht (50) zugewandt ist, von dem Abschnitt, der der p-Typ-Nanokristall-Siliziumschicht zugewandt ist, klein wird.

4. Solarzelle nach Anspruch 1,
wobei die intrinsische Halbleiterschicht (40) eine optische Bandlücke mit einem größeren Wert an dem Abschnitt, der der p-Typ-Nanokristall-Siliziumschicht (30) zugewandt ist, als dem Abschnitt, der der n-Typ-Nanokristall-Siliziumschicht zugewandt ist, aufweist.

5. Solarzelle nach Anspruch 4,
wobei eine Kristallstrukturgröße der intrinsischen Halbleiterschicht (40) allmählich zu dem Abschnitt, der der n-Typ-Nanokristall-Siliziumschicht (50) zugewandt ist, von dem Abschnitt, der der p-Typ-Nanokristall-Siliziumschicht zugewandt ist, groß wird.

6. Solarzelle nach Anspruch 1,
wobei die p-Typ-Nanokristall-Siliziumschicht (30) eine Dicke von 0,5 nm bis 1000 µm aufweist.

7. Solarzelle nach Anspruch 1,
wobei die intrinsische Halbleiterschicht (40) eine Dicke von 0,5 nm bis 1000 µm aufweist.

8. Solarzelle nach Anspruch 1,
wobei die n-Typ-Nanokristall-Siliziumschicht (50) eine Dicke von 0,5 nm bis 1000 µm aufweist.

9. Verfahren zum Bilden einer Solarzelle, die laminiert ist, um mehrere Bandlückenwerte aufzuweisen, umfassend:
(a) Bilden eines unteren Elektrodenleiters (20) auf einem Substrat (10);
(b) Bilden einer p-Typ-Nanokristall-Siliziumschicht (30) auf dem unteren Elektrodenleiter (20);
(c) Bilden einer intrinsischen Halbleiterschicht (40), die eine Nanokristall-Siliziumschicht umfasst, durch Bestrahlung durch eine Neutralteilchenstrahlvorrichtung (201) auf der p-Typ-Nanokristall-Siliziumschicht (30);
(d) Bilden einer n-Typ-Nanokristall-Siliziumschicht (50) auf der intrinsischen Halbleiterschicht (40) und
(e) Bilden einer Antireflexfolie (60) auf der n-Typ-Nanokristall-Siliziumschicht (50);
wobei die optische Bandlücke mehrere Bandlückenwerte in Abhängigkeit von der abgeschiedenen Höhe aufweist,
wobei im Schritt (c) die Energie, die zur Produktion von Neutralteilchenstrahlen in der Neutralteilchenstrahlvorrichtung (201) zugeführt werden soll, gemäß einer abgeschiedenen Höhe der intrinsischen Halbleiterschicht (40) gesteuert wird,
die Nanokristall-Siliziumschicht eine Nanokristallstruktur und eine optische Bandlücke aufweist, die gemäß einer Veränderung in der Nanokristallstruktur davon aufgrund der abgeschiedenen Höhe der intrinsischen Halbleiterschicht (40) variiert, und
wobei im Schritt (c) die Energie, die der Neutralteilchenstrahlvorrichtung (201) zugeführt wird, allmählich erhöht wird, während die abgeschiedene Höhe der intrinsischen Halbleiterschicht (40) höher wird, so dass die optische Bandlücke der intrinsischen Halbleiterschicht (40) allmählich kleiner wird, oder
die Energie, die der Neutralteilchenstrahlvorrichtung (201) zugeführt wird, allmählich verringert wird, während die abgeschiedene Höhe der intrinsischen Halbleiterschicht (40) höher wird, so dass die optische Bandlücke der intrinsischen Halbleiterschicht (40) allmählich größer wird.

10. Verfahren zum Bilden einer Solarzelle nach Anspruch 9,
wobei in den Schritten (b) oder (d) die Nanokristall-Siliziumschicht durch Neutralteilchenstrahlbestrahlung gebildet wird.

## Revendications

1. Cellule solaire stratifiée pour avoir plusieurs valeurs de bande interdite, comprenant :
un substrat (10) ;
un conducteur d'électrode inférieur (20) empilé sur le substrat (10) ;
une couche de silicium nanocristallin de type p (30) dopée avec des impuretés de type p, dans laquelle la couche de silicium nanocristallin de type p (30) est empilée sur le conducteur d'électrode inférieur ;
une couche semi-conductrice intrinsèque (40) empilée sur la couche de silicium nanocristallin de type p ;
une couche de silicium nanocristallin de type n (50) dopée avec des impuretés de type n, dans laquelle la couche de silicium nanocristallin de type n (50) est empilée sur la couche semi-conductrice intrinsèque, et
un film anti-reflet (60) empilé sur la couche de silicium nanocristallin de type n (50),
dans laquelle la couche semi-conductrice intrinsèque (40) est formée par irradiation par un dispositif à faisceau de particules neutres (201), qui commande l'énergie d'irradiation en fonction d'une hauteur déposée de la couche semi-conductrice intrinsèque (40),
la couche semi-conductrice intrinsèque (40) comprend une couche de silicium nanocristallin qui a une structure nanocristalline et une bande optique interdite qui varie en fonction d'un changement de sa structure nanocristalline en raison de la hauteur déposée de la couche semi-conductrice intrinsèque (40), et
la bande optique interdite a plusieurs valeurs de bande interdite en fonction de la hauteur déposée,
dans laquelle l'énergie fournie au dispositif à faisceau de particules neutres (201) augmente progressivement à mesure que la hauteur déposée de la couche semi-conductrice intrinsèque (40) augmente, de sorte que la bande optique de la couche semi-conductrice intrinsèque (40) devient progressivement plus petite, ou
l'énergie fournie au dispositif à faisceau de particules neutres (201) est progressivement réduite à mesure que la hauteur déposée de la couche semi-conductrice intrinsèque (40) augmente, de sorte que la bande optique interdite de la couche semi-conductrice intrinsèque (40) devient progressivement plus grande.

2. Cellule solaire selon la revendication 1,
dans laquelle la couche semi-conductrice intrinsèque (40) a une bande optique interdite ayant une valeur plus petite dans une partie faisant face à la couche de silicium nanocristallin de type p (30) que dans une partie faisant face à la couche de silicium nanocristallin de type n.

3. Cellule solaire selon la revendication 2,
dans laquelle une taille de structure cristalline de la couche semi-conductrice intrinsèque (40) devient progressivement petite vers la partie faisant face à la couche de silicium nanocristallin de type n (50) depuis la partie faisant face à la couche de silicium nanocristallin de type p.

4. Cellule solaire selon la revendication 1,
dans laquelle la couche semi-conductrice intrinsèque (40) a une bande optique interdite ayant une valeur plus grande dans la partie faisant face à la couche de silicium nanocristallin de type p (30) que dans la partie faisant face à la couche de silicium nanocristallin de type n.

5. Cellule solaire selon la revendication 4,
dans laquelle une taille de structure cristalline de la couche semi-conductrice intrinsèque (40) devient progressivement grande vers la partie faisant face à la couche de silicium nanocristallin de type n (50) depuis la partie faisant face à la couche de silicium nanocristallin de type p.

6. Cellule solaire selon la revendication 1,
dans laquelle la couche de silicium nanocristallin de type p (30) a une épaisseur de 0,5 nm à 1 000 µm.

7. Cellule solaire selon la revendication 1,
dans laquelle la couche semi-conductrice intrinsèque (40) a une épaisseur de 0,5 nm à 1 000 µm.

8. Cellule solaire selon la revendication 1,
dans laquelle la couche de silicium nanocristallin de type n (50) a une épaisseur de 0,5 nm à 1 000 µm.

9. Procédé de formation d'une cellule solaire stratifiée pour avoir plusieurs valeurs de bande interdite, comprenant :
**(a)** la formation d'un conducteur d'électrode inférieur (20) sur un substrat (10) ;
**(b)** la formation d'une couche de silicium nanocristallin de type p (30) sur le conducteur d'électrode inférieur (20) ;
**(c)** la formation d'une couche semi-conductrice intrinsèque (40) comprenant une couche de silicium nanocristallin par irradiation par un dispositif à faisceau de particules neutres (201), sur la couche de silicium nanocristallin (30) de type p ;
**(d)** la formation d'une couche de silicium nanocristallin de type n (50) sur la couche semi-conductrice intrinsèque (40) ; et
**(e)** la formation d'un film anti-reflet (60) sur la couche de silicium nanocristallin de type n (50),
dans lequel la bande optique interdite a plusieurs valeurs de bande interdite en fonction de la hauteur déposée,
dans lequel, dans l'étape (c), l'énergie à fournir pour la production de faisceaux de particules neutres dans le dispositif à faisceau de particules neutres (201) est commandée en fonction d'une hauteur déposée de la couche semi-conductrice intrinsèque (40),
la couche de silicium nanocristallin a une structure nanocristalline et une bande optique interdite qui varie en fonction d'un changement de sa structure nanocristalline en raison de la hauteur déposée de la couche semi-conductrice intrinsèque (40) et
dans lequel, dans l'étape (c), l'énergie fournie au dispositif à faisceau de particules neutres (201) augmente progressivement à mesure que la hauteur déposée de la couche semi-conductrice intrinsèque (40) augmente, de sorte que la bande optique interdite de la couche semi-conductrice intrinsèque (40) devient progressivement plus petite ou, dans l'étape (c), l'énergie fournie au dispositif à faisceau de particules neutres (201) est progressivement réduite à mesure que la hauteur déposée de la couche semi-conductrice intrinsèque (40) augmente, de sorte que la bande optique interdite de la couche semi-conductrice intrinsèque (40) devient progressivement plus grande.

10. Procédé de formation d'une cellule solaire selon la revendication 9,
dans lequel, dans les étapes (b) ou (d), la couche de silicium nanocristallin est formée par irradiation par un faisceau de particules neutres.
